# EUROPEAN PATENT APPLICATION

(11) **EP 4 394 900 A1**
(43) Date of publication of application: **03.07.2024**
(21) Application number: 22928443.5
(22) Date of filing: 23.12.2022
(51) Int. Cl.: H01L 31/18, H01L 21/228, H01L 21/316

(54) **METHOD FOR TREATING SEMICONDUCTOR SUBSTRATE LAYER AND METHOD FOR PREPARING SOLAR CELL**

(30) Priority: 28.02.2022 CN 202210189426
(71) Applicant: Anhui Huasun Energy Co., Ltd., Xuancheng, Anhui 242000 (CN)
(72) Inventor: ZHANG, Liang, Xuancheng, Anhui 242000 (CN); ZHANG, Jing, Xuancheng, Anhui 242000 (CN); ZHOU, Xiwei, Xuancheng, Anhui 242000 (CN); ZHOU, Su, Xuancheng, Anhui 242000 (CN); GONG, Daoren, Xuancheng, Anhui 242000 (CN); XU, Xiaohua, Xuancheng, Anhui 242000 (CN)
(74) Representative: Potter Clarkson
(86) International application number: PCT/CN2022/141510
(87) International publication number: WO 2023/160200

(57) **Abstract**

Provided in the present application are a method for treating a semiconductor substrate layer and a method for preparing a solar cell. The method for treating a semiconductor substrate layer comprises a step of providing a monocrystalline silicon wafer, a step of spraying a diffusion liquid onto a surface of the monocrystalline silicon wafer, and a step of annealing the monocrystalline silicon wafer, and further comprises subjecting the monocrystalline silicon wafer to a surface oxidation treatment before spraying the diffusion liquid onto the surface of the monocrystalline silicon wafer, wherein the surface oxidation treatment is used for improving the lyophilicity of the surface of the monocrystalline silicon wafer to the diffusion liquid, so as to improve the uniformity of the annealing treatment of the monocrystalline silicon wafer. The method for treating a semiconductor substrate layer provided in the present application can solve the problem of non-uniform spreading of a diffusion liquid, thereby greatly improving the performance of the semiconductor substrate layer.

## Description

The present application claims priority to Chinese Patent Application No. 202210189426.0, entitled "METHOD FOR TREATING SEMICONDUCTOR SUBSTRATE LAYER AND METHOD FOR PREPARING SOLAR CELL", and filed to the China National Intellectual Property Administration on February 28, 2022, the entire contents of which are incorporated herein by reference.

### TECHNICAL FIELD

The present disclosure relates to the technical field of solar cell manufacturing, in particular to a method for treating a semiconductor substrate layer and a method for preparing a solar cell.

### BACKGROUND

Solar cells have the advantages of being clean, pollution-free, renewable, and having stable working performance. Solar cells are divided into different types according to their structure, preparation process, and materials used, comprising: silicon-based solar cells, multi-compound thin film solar cells, polymer multi-layer modified electrode solar cells, organic solar cells, etc. Among them, silicon-based solar cells are the most mature ones, such as heterojunction solar cells. Taking heterojunction solar cells as an example, a semiconductor layer, a transparent conductive layer, and a metal electrode are prepared on one or both sides of an N-type substrate to form a cell sheet, and then multiple cell sheets are interconnected and packaged to form a module. The module generates electricity, which is then fed back to the power grid through an inverter.

The N-type substrate is usually a monocrystalline silicon wafer, which is obtained by drawing and cutting a monocrystalline silicon rod. In the process of drawing monocrystalline silicon rods, due to the very small segregation coefficient of metal impurities, there will be differences in metal content at the beginning and end of a monocrystalline silicon rod; in particular, the existing technology usually uses a continuous feeding and drawing method, which can continuously draw multiple monocrystalline silicon rods, the metal impurities in the monocrystalline silicon rods drawn later are greater than those in the monocrystalline silicon rods drawn earlier in a single batch. When monocrystalline silicon wafers are used to prepare solar cells, due to the presence of metal impurities, recombination of metal impurities and minority carriers will occur, which will affect the photoelectric conversion efficiency, thereby affecting the conversion efficiency of high-efficiency cells, and lead to a decrease in service life.

Gettering is an important way to improve the crystal quality of monocrystalline silicon wafers. The content of metal impurities in monocrystalline silicon wafers can be reduced through gettering, thereby making the quality consistency of monocrystalline silicon wafers better, so that the conversion efficiency of high-efficiency cells is more concentrated. At present, one of the main methods is phosphoric acid chain spray gettering, which uses phosphoric acid as a diffusion liquid to spray onto the surface of the monocrystalline silicon wafer. The phosphoric acid naturally spreads and then undergoes diffusion annealing to form a doped layer. In this process, the metal impurities in the monocrystalline silicon wafers are precipitated to the doped layer, and finally, the doped layer is removed to achieve the purpose of impurity removal. However, when the monocrystalline silicon wafer of the substrate is treated with the phosphoric acid chain spraying gettering method, the phosphoric acid tends to spread non-uniform on the surface of the monocrystalline silicon wafer, which may lead to unsatisfactory service life and photoelectric conversion efficiency of the final solar cell. Therefore, a solution is needed to solve the problem of non-uniform spreading of phosphoric acid.

### SUMMARY OF THE INVENTION

The present application provides a method for treating a semiconductor substrate layer and a method for preparing a solar cell to solve the problem of non-uniform spreading of diffusion liquid.

The present application provides a method for treating a semiconductor substrate layer, comprising a step of providing a monocrystalline silicon wafer, a step of spraying a diffusion liquid onto the surface of the monocrystalline silicon wafer, and a step of annealing the monocrystalline silicon wafer; wherein the method further comprises the following steps: subjecting the monocrystalline silicon wafer to a surface oxidation treatment before spraying the diffusion liquid onto the surface of the monocrystalline silicon wafer, wherein the surface oxidation treatment is used for improving the lyophilicity of the surface of the monocrystalline silicon wafer to the diffusion liquid, to improve the uniformity of the annealing the monocrystalline silicon wafer.

Optionally, the step of surface oxidation treatment comprises: spraying an oxygen-containing gas onto the surface of the monocrystalline silicon wafer.

Optionally, the oxygen-containing gas comprises ozone.

Optionally, the concentration of the oxygen-containing gas is in a range from 50 ppm to 300 ppm.

Optionally, the injection rate of the oxygen-containing gas is in a range from 0.5slm to 5slm.

Optionally, the oxygen-containing gas is sprayed for a period ranging from 5 seconds to 30 seconds.

Optionally, in the step of the surface oxidation treatment, the oxygen-containing gas is sprayed vertically toward the surface of the monocrystalline silicon wafer.

Optionally, the surface oxidation treatment causes an oxide layer to be formed on the surface of the monocrystalline silicon wafer; the method for treating a semiconductor substrate layer also comprises performing diffusion annealing treatment on the surface of the monocrystalline silicon wafer, which causes the diffusion ions in the diffusion liquid to diffuse into the partial thickness of the monocrystalline silicon wafer through the oxide layer, to form a doped layer covered by the oxide layer in the partial thickness of the monocrystalline silicon wafer, and the diffusion annealing treatment is suitable for migrating impurities inside the monocrystalline silicon wafer to the doped layer.

Optionally, the diffusion annealing treatment is a chain diffusion annealing treatment.

Optionally, the surface oxidation treatment causes an oxide layer to be formed on the surface of the monocrystalline silicon wafer, and the oxide layer has a thickness ranging from 0.5nm to 20nm.

Optionally, the material of the monocrystalline silicon wafer comprises monocrystalline silicon, and the material of the oxide layer comprises silicon oxide.

Optionally, the step of performing diffusion annealing treatment on the surface of the monocrystalline silicon wafer comprises: a heating process, a heat preservation process, and a cooling process in sequence, the heat preservation process is suitable for diffusing the diffusion ions into the partial thickness of the monocrystalline silicon wafer, and the cooling process is suitable for migrating impurities inside the monocrystalline silicon wafer into the doped layer.

Optionally, the temperature of the heat preservation process is in a ranging from 800°C to 900°C.

Optionally, the doped layer has a thickness ranging from 0.15 µm to 0.3 µm.

Optionally, the diffusion liquid comprises a phosphoric acid solution.

Optionally, the mass concentration of the phosphoric acid solution is in the range from 2% to 12%.

Optionally, before performing surface oxidation treatment on the monocrystalline silicon wafer, the method further comprises: removing a damaged layer on the surface of the monocrystalline silicon wafer; performing a dehydration treatment to the surface of the monocrystalline silicon wafer using a hydrophobic solution after removing the damaged layer on the surface of the monocrystalline silicon wafer; and drying the monocrystalline silicon wafer after the dehydration treatment.

Optionally, an etching solution used for removing the damaged layer on the surface of the monocrystalline silicon wafer is a NaOH aqueous solution, a KOH aqueous solution, or a mixed solution of HF and HNOs.

Optionally, the hydrophobic solution comprises an HF aqueous solution.

Optionally, the mass concentration of the NaOH aqueous solution is in the range from 2% to 15%.

Optionally, the mass concentration of the KOH aqueous solution is in a range from 2% to 15%.

Optionally, the mixed solution of HF and HNO₃ is prepared from HF with a mass concentration ranging from 45% to 50% and HNO₃ with a mass concentration ranging from 60% to 70% in a volume ratio of 1:3 to 1:9.

Optionally, after performing the diffusion annealing treatment, the method further comprises: removing the oxide layer; and removing the doped layer after removing the oxide layer.

Optionally, the etching solution for removing the oxide layer is an HCl aqueous solution, and the mass concentration of the HCl aqueous solution is in a range of 4% to 5%.

Optionally, the etching solution used for removing the doped layer is a NaOH aqueous solution or a KOH aqueous solution. Optionally, a mixed solution of HF and HNOs is used for removing the oxide layer and removing the doped layer.

Optionally, the mass concentration of the NaOH aqueous solution is in the range from 2% to 15%.

Optionally, the mass concentration of the KOH aqueous solution is in a range from 2% to 15%.

Optionally, the mixed solution of HF and HNO₃ is prepared from HF with a mass concentration ranging from 45% to 50% and HNO₃ with a mass concentration ranging from 60% to 70% in a volume ratio of 1:3 to 1:9.

Optionally, after removing the doped layer, the method further comprises: cleaning the monocrystalline silicon wafer using a neutralizing cleaning solution.

Optionally, the neutralizing cleaning solution is a mixed solution of HF and HCl.

The present application also provides a method for preparing a solar cell, wherein the method comprises the method for treating a semiconductor substrate layer provided in the present application.

Optionally, after treating the semiconductor substrate layer, the method for preparing a solar cell further comprises the following steps: performing texturing treatment on the semiconductor substrate layer; forming a first intrinsic semiconductor layer on one side surface of the semiconductor substrate layer after performing texturing treatment, and forming a second intrinsic semiconductor layer on the other side surface of the semiconductor substrate layer; forming a first doped semiconductor layer on the side of the first intrinsic semiconductor layer facing away from the semiconductor substrate layer, and forming a second doped semiconductor layer on a side of the second intrinsic semiconductor layer facing away from the semiconductor substrate layer; forming a first transparent conductive film on a side of the first doped semiconductor layer facing away from the semiconductor substrate layer, and forming a second transparent conductive film on a side of the second doped semiconductor layer facing away from the semiconductor substrate layer; and forming a first grid electrode on a side of the first transparent conductive film facing away from the semiconductor substrate layer, and forming a second grid electrode on a side of the second transparent conductive film facing away from the semiconductor substrate layer.

The beneficial effects of the present application are as follows.

The method for treating a semiconductor substrate layer provided by the present application involves subjecting the monocrystalline silicon wafer to a surface oxidation treatment before spraying the diffusion liquid onto the surface of the monocrystalline silicon wafer. Through surface oxidation treatment, an oxide layer can be formed on the surface of the monocrystalline silicon wafer in advance. The oxide layer on the surface of the monocrystalline silicon wafer has a better lyophilicity for the diffusion liquid, therefore the diffusion liquid spreads better during the spraying process of the diffusion liquid, and the diffusion liquid has a faster spreading speed. As a result, the diffusion liquid spreads more uniformly on the surface of the monocrystalline silicon wafer.

Further, performing diffusion annealing treatment on the surface of the monocrystalline silicon wafer causes the diffusion ions in the diffusion liquid to diffuse into the partial thickness of the monocrystalline silicon wafer through the oxide layer, so as to form a doped layer covered by the oxide layer in the partial thickness of the monocrystalline silicon wafer, and the diffusion annealing treatment is suitable for migrating impurities inside the monocrystalline silicon wafer to the doped layer. Since the spreading of the diffusion liquid on the surface of the monocrystalline silicon wafer is more uniform, the distribution of diffusion ions in the doped layer is more uniform, which makes the impurity absorption effect of the doped layer more consistent in different regions, greatly improving the performance of the semiconductor substrate layer..

### BRIEF DESCRIPTION OF THE DRAWINGS

To illustrate the specific embodiments of the present invention or the technical solutions in the prior art more clearly, the following briefly introduces the accompanying drawings that need to be used in the description of the specific embodiments or the prior art. The accompanying drawings in the following description are some embodiments of the present application. For those of ordinary skill in the art, other drawings can also be obtained based on these drawings without creative efforts.
FIG. 1 is a flow chart of a method for treating a semiconductor substrate layer in an embodiment of the present application;
FIG. 2 is a detailed flow chart of a method for treating a semiconductor substrate layer in an embodiment of the present application;
FIG. 3 to FIG. 9 are structural schematic diagrams of the treating process of the semiconductor substrate layer in an embodiment of the present application.

### Reference signs:

100-monocrystalline silicon wafer; 110-damaged layer; 120-oxide layer; 120'-oxide layer; 130-doped layer; 200-semiconductor substrate layer.

### DETAILED DESCRIPTION

As mentioned in the background art, after the monocrystalline silicon wafer of the substrate is treated by the chain phosphoric acid gettering method, the final photoelectric conversion efficiency and the service life of the solar cell may still be unsatisfactory. The inventor's research found that the specific reason is that during the process of phosphoric acid chain impurity absorption, the spreading ability of phosphoric acid as a diffusion liquid is poor and the spreading speed is slow. The slow spreading speed of the diffusion liquid can easily lead to non-uniform distribution of phosphoric acid on the surface of monocrystalline silicon wafers, which may cause local completed impurity absorption and corrosion, but there are still other areas that have not completed impurity absorption.

To solve the problem of non-uniform spreading of the above-mentioned diffusion liquid, the present application provides a method for treating a semiconductor substrate layer, comprising a step of providing a monocrystalline silicon wafer, a step of spraying a diffusion liquid onto a surface of the monocrystalline silicon wafer, and also comprising the following steps: subjecting the monocrystalline silicon wafer to a surface oxidation treatment before spraying the diffusion liquid onto the surface of the monocrystalline silicon wafer, wherein the surface oxidation treatment is used for improving the lyophilicity of the surface of the monocrystalline silicon wafer to the diffusion liquid.

The technical solutions of the present application will be clearly and completely described below in conjunction with the drawings. The described embodiments are some of the embodiments of the present application, not all of them. Based on the embodiments in this application, all other embodiments obtained by those skilled in the art without paying creative efforts belong to the scope of protection of the present application.

In the description of the present application, it should be noted that the terms "center", "upper", "lower", "left", "right", "vertical", "horizontal", "inner", "outer" etc. indicated orientation or positional relationship is based on the orientation or positional relationship shown in the drawings, and is only for the convenience of describing the present application and simplifying the description, rather than indicating or implying that the referred device or element must have a specific orientation, use a specific orientation construction and operation, therefore should not be construed as limiting the application. In addition, the terms "first", "second", and "third" are used for descriptive purposes only, and should not be construed as indicating or implying relative importance.

In the description of the present application, it should be noted that unless otherwise specified and limited, the terms "installation", "connected", and "connection" should be understood in a broad sense, for example, it can be fixed connections, removable connections, or integrated connections; it can be mechanically or electrically connected; it can be directly connected, or indirectly connected through an intermediary, or it can be the internal communication of two components, which can be wireless or wired connect. Those skilled in the art can understand the specific meanings of the above terms in the present application in specific situations.

In addition, the technical features involved in the different embodiments of the present application described below may be combined as long as they do not constitute a conflict with each other.

### EXAMPLE 1

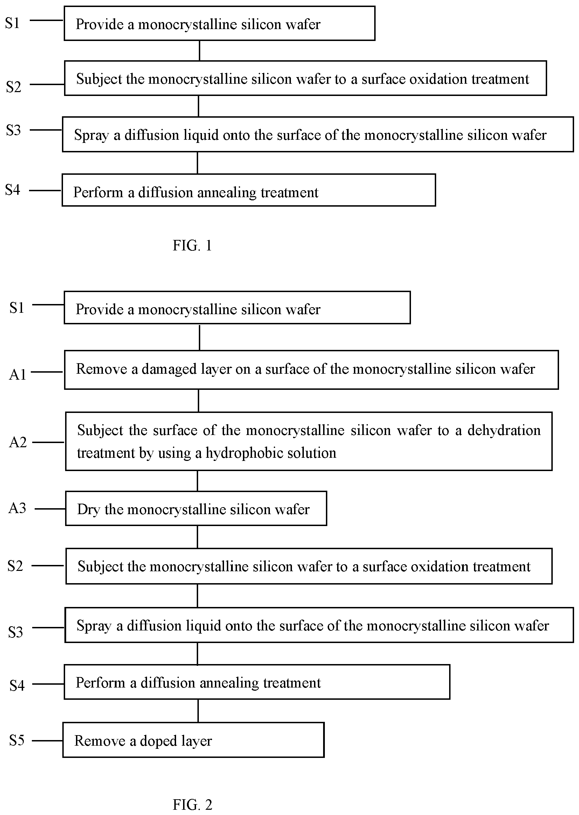

This example provides a method for treating a semiconductor substrate layer, referring to FIG. 1, which comprises:
Step S1: providing a monocrystalline silicon wafer;
Step S2: performing surface oxidation treatment on the monocrystalline silicon wafer;
Step S3: spraying a diffusion liquid onto a surface of the monocrystalline silicon wafer;
Step S4: performing a diffusion annealing treatment on the surface of the monocrystalline silicon wafer.

In the present application, the surface oxidation treatment is used for improving the lyophilicity of the surface of the monocrystalline silicon wafer to the diffusion liquid. The diffusion liquid is used to form a doped layer in the step of diffusion annealing, and absorb and remove metal impurities in the monocrystalline silicon wafer.

The method for treating a semiconductor substrate layer in this example involves subjecting the monocrystalline silicon wafer to a surface oxidation treatment before spraying the diffusion liquid onto the surface of the monocrystalline silicon wafer. Through surface oxidation treatment, an oxide layer can be formed on the surface of the monocrystalline silicon wafer in advance. The oxide layer on the surface of the monocrystalline silicon wafer has a better lyophilicity for the diffusion liquid, therefore the diffusion liquid spreads better during the spraying process of the diffusion liquid, and the diffusion liquid has a faster spreading speed. As a result, the diffusion liquid spreads more uniformly on the surface of the monocrystalline silicon wafer, thereby increasing the uniformity of the annealing treatment of the monocrystalline silicon wafer, and greatly improving the performance of the semiconductor substrate layer.

In this example, referring to FIG. 2, before performing surface oxidation treatment on the monocrystalline silicon wafer, the method further comprises step A1: removing a damaged layer on the surface of the monocrystalline silicon wafer; step A2: performing a dehydration treatment to the surface of the monocrystalline silicon wafer using a hydrophobic solution after removing the damaged layer on the surface of the monocrystalline silicon wafer; step A3: drying the monocrystalline silicon wafer after performing the dehydration treatment.

In this example, referring to FIG. 2, the method further comprises step S5: removing the doped layer after performing the diffusion annealing treatment.

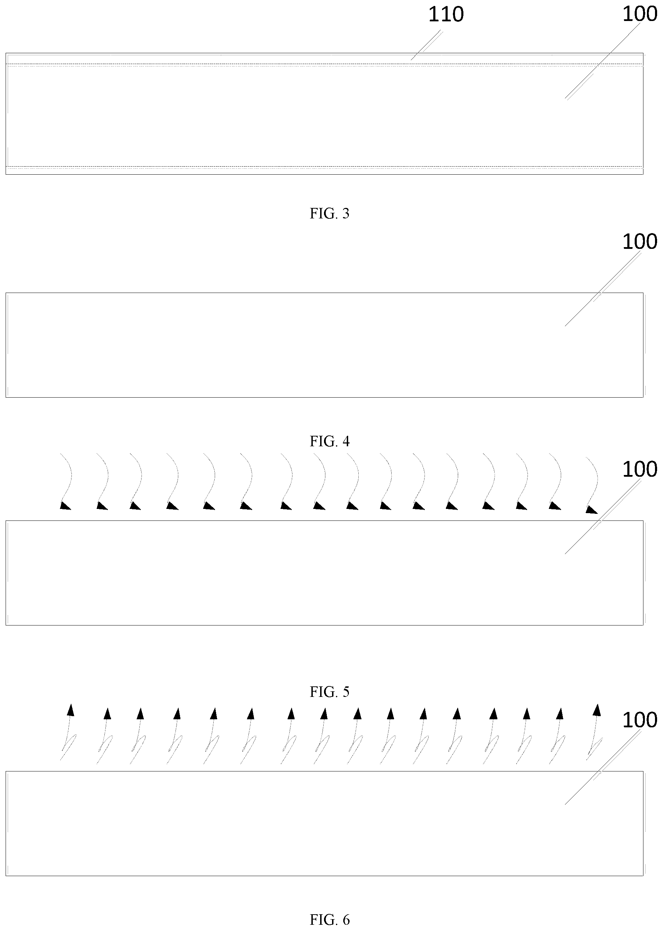

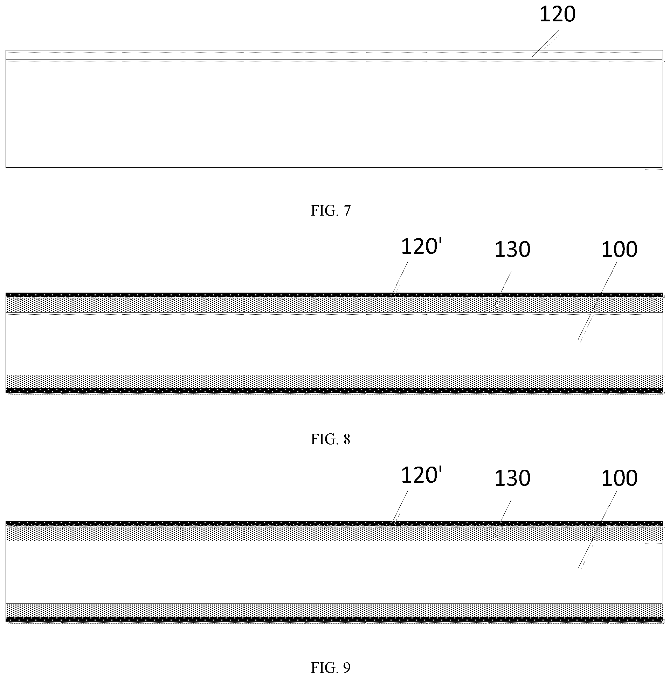

A detailed description will be given below concerning FIG. 3to FIG. 9.

Referring to FIG. 3, a monocrystalline silicon wafer 100 is provided.

The material of the monocrystalline silicon wafer 100 comprises monocrystalline silicon. In other examples, the material of the monocrystalline silicon wafer is other semiconductor materials, such as germanium or silicon germanium. The material of the semiconductor substrate layer may also be other semiconductor materials.

In this example, the conductivity type of the monocrystalline silicon wafer 100 is N-type, the conductivity type of the semiconductor substrate layer formed subsequently is N-type, and the semiconductor substrate layer is used for solar cells. It should be noted that in other examples, the conductivity type of the monocrystalline silicon wafer is P-type.

In this example, the surface of the monocrystalline silicon wafer 100 has a damaged layer 110. In a specific example, the monocrystalline silicon wafer 100 has a damaged layer 110 on both the front and back sides. The damaged layer 110 is caused during the process of cutting the monocrystalline raw material to form the monocrystalline silicon wafer 100.

Referring to FIG. 4, the damaged layer 110 on the surface of the monocrystalline silicon wafer 100 (FIG. 3) is removed.

In this example, the process of removing the damaged layer 110 comprises a wet etching process. In a specific example, an etching solution used for removing the damaged layer 110 on the surface of the monocrystalline silicon wafer 100 is a NaOH aqueous solution, a KOH aqueous solution or a mixed solution of HF and HNOs; when the etching solution used for removing the damaged layer on the surface of the monocrystalline silicon wafer is NaOH aqueous solution, the mass concentration of the NaOH aqueous solution is in a range from 2% to 15%; when the etching solution used for removing the damaged layer on the surface of the monocrystalline silicon wafer is KOH aqueous solution, the mass concentration of the KOH aqueous solution is in a range from 2% to 15%; when the etching solution used for removing the damaged layer on the surface of the monocrystalline silicon wafer is a mixed solution of HF and HNOs, the mixed solution of HF and HNOs is prepared from HF with a mass concentration ranging from 45% to 50% and HNO₃ with a mass concentration ranging from 60% to 70% in a volume ratio of 1:3 to 1:9.

Referring to FIG. 5, the dehydration treatment to the surface of the monocrystalline silicon wafer using a hydrophobic solution is performed after removing the damaged layer 110 on the surface of the monocrystalline silicon wafer 100.

The hydrophobic solution comprises an HF aqueous solution.

In other examples, when the etching solution used for removing the damaged layer 110 is a NaOH aqueous solution or a KOH aqueous solution, before the dehydration treatment, the method further comprises: using a neutralization treatment liquid to remove the residual etching solution. The neutralization treatment liquid is a mixed solution of HF and HCl.

Referring to FIG. 6, after the dehydration treatment, the monocrystalline silicon wafer 100 is dried.

Referring to FIG. 7, the surface oxidation treatment is performed on the monocrystalline silicon wafer 100. The surface oxidation treatment causes the oxide layer 120 to be formed on the surface of the monocrystalline silicon wafer 100. The surface oxidation treatment can improve the uniformity of the diffusion liquid spreading on the surface of the initial semiconductor layer 100 during the subsequent spraying of the diffusion liquid on the surface of the monocrystalline silicon wafer 100.

In one example, the oxide layer 120 has a thickness ranging from 0.5nm to 20nm, such as 0.5nm, 1nm, or 2nm.

Since the oxide layer 120 itself is very thin, it will not affect the diffusion of diffusion ions in the diffusion liquid through the oxide layer 120 in the subsequent step of diffusion annealing treatment.

When the material of the monocrystalline silicon wafer is monocrystalline silicon, the material of the oxide layer 120 is silicon oxide.

The step of performing surface oxidation treatment comprises spraying oxygen-containing gas onto the surface of the monocrystalline silicon wafer 100.

Specifically, the oxygen-containing gas may be ozone. Ozone has better oxidizing ability.

In one example, the concentration of the oxygen-containing gas is in the range from 50 ppm to 300 ppm, such as 50 ppm, 100 ppm, 150 ppm, 200 ppm, 250 ppm, or 300 ppm. If the concentration of oxygen-containing gas is too low, the oxidation rate will be slow and the process efficiency will be reduced; if the concentration of oxygen-containing gas is too high, the oxidation rate will be too fast and the oxidation process will be difficult to control well.

In one example, the injection rate of the oxygen-containing gas is in a range from 0.5 slm to 5 slm (standard liter per minute), such as 0.5 slm, 1 slm, 2 slm, 4 slm, or 5 slm. If the injection rate of oxygen-containing gas is too low, the oxidation rate will be slow and the process efficiency will be reduced; if the injection rate of oxygen-containing gas is too fast, the oxidation rate will be too fast and the oxidation process will be difficult to control well, and it will also cause insufficient utilization of oxygen-containing gas, leading to more waste.

In one example, the oxygen-containing gas is sprayed for a period ranging from 5 seconds to 30 seconds, such as 5s, 10s, 15s, 20s, 25s, or 30s. If the period for spraying oxygen-containing gas is too short, the oxidation will be insufficient, the thickness of the oxide layer 120 is too thin, the uniformity of the oxide layer 120 will be poor, and the degree of the uniformity of the spread of the diffusion liquid on the surface of the monocrystalline silicon wafer will be improved; if the time for spraying oxygen-containing gas is too long, the oxide layer 120 is too thick, which is not conducive to the diffusion of diffusion ions in the diffusion liquid.

The oxygen-containing gas is preferably sprayed vertically toward the monocrystalline silicon wafer 100.

In some examples, oxygen-containing gas is sprayed onto the surfaces of both opposite sides of the monocrystalline silicon wafer 100, and an oxide layer 120 is formed on both opposite sides of the monocrystalline silicon wafer 100.

Referring to FIG. 8, a diffusion liquid is sprayed on the surface of the monocrystalline silicon wafer 100; and then a diffusion annealing treatment is performed on the surface of the monocrystalline silicon wafer 100, which causes the diffusion ions in the diffusion liquid to diffuse into partial thickness of the monocrystalline silicon wafer through the oxide layer 120, to form a doped layer 130 covered by the oxide layer 120 in the partial thickness of the monocrystalline silicon wafer 100, and the diffusion annealing treatment is suitable for migrating impurities inside the monocrystalline silicon wafer 100 to the doped layer 130.

The solid solubility of the metal impurities in the doped layer 130 is increased compared to the initial semiconductor layer, therefore the metal impurities will gradually migrate into the doped layer 130 from the portion of the initial semiconductor layer where the doped layer 130 is not formed. In this example, after the diffusion annealing treatment is performed, the oxide layer 120 is also doped with diffusion ions. When the material of the oxide layer 120 is silicon oxide and the diffusion ions are phosphorus ions, the oxide layer 120' doped with diffusion ions is formed from the oxide layer 120 after the diffusion annealing treatment, and the oxide layer 120' is phosphorus silicon glass (PSG).

In this example, the step of spraying the diffusion liquid on the surface of the monocrystalline silicon wafer is specifically: spraying phosphoric acid on the surface of the initial semiconductor layer, and the phosphoric acid naturally spreads on the surface of the initial semiconductor layer. The concentration of phosphoric acid solution is in a range from 2% to 12%.

In some examples, the diffusion liquid is sprayed onto the surfaces of both opposite sides of the monocrystalline silicon wafer 100 respectively, and a doped layer 130 is formed on both opposite sides of the monocrystalline silicon wafer 100.

In this example, the steps of diffusion annealing treatment comprise: a heating process, a heat preservation process, and a cooling process in sequence, the heat preservation process is suitable for diffusing the diffusion ions into the partial thickness of the monocrystalline silicon wafer, and the cooling process is suitable for migrating impurities inside the monocrystalline silicon wafer into the doped layer. In this example, the diffusion annealing treatment is a chain diffusion annealing treatment, which is performed in a chain diffusion annealing furnace.

The time for the heating process is in a range from 50s to 100s, such as 50s, 60s, 70s, 80s, 90s, or 100s. The heating process starts from room temperature until the temperature reach 800°C to 900°C, such as 800°C, 850°C, or 900°C. The temperature during the heat preservation process is maintained at 800°C to 900°C. The time for the cooling process is in a range from 50s to 100s, such as 50s, 60s, 70s, 80s, 90s, or 100s. During the cooling process, the temperature is reduced by 300°C to 500°C from the temperature during the heat preservation process.

In this example, the material of the initial semiconductor layer 100 is monocrystalline silicon, and the doped layer 130 is a phosphorus-doped silicon layer. The doped layer 130 has a thickness ranging from 0.15 µm to 0.3 µm, such as 0.15 µm, 0.2 µm, 0.25 µm, or 0.3 µm.

Since the diffusion liquid spreads more uniformly on the surface of the monocrystalline silicon wafer, the distribution of diffused ions in the doped layer is more uniform, thereby the gettering effect of the doped layer more consistent in different areas.

Referring to FIG. 9, the oxide layer 120' is removed; after the oxide layer 120' is removed, the doped layer 130 is removed to form a semiconductor substrate layer 200.

In this example, the etching solution for removing the oxide layer 120' is an HCl aqueous solution, and the mass concentration of the HCl aqueous solution is in a range from 4% to 5%, such as 4% or 5%. In this example, the process for removing the doped layer 130 comprises a wet etching process. In a specific example, the etching solution used for removing the doped layer 130 is a NaOH aqueous solution or a KOH aqueous solution. When the etching solution used to remove the doped layer 130 is a NaOH aqueous solution, the mass concentration of the NaOH aqueous solution is in a range from 2% to 15%; when the etching solution used to remove the doped layer 130 is a KOH aqueous solution, the mass concentration of the KOH aqueous solution is in a range from 2% to 15%.

In other examples, a mixed solution of HF and HNO₃ is used for removing the oxide layer 120' and the doped layer 130. When the etching solution used for removing the oxide layer 120' and the doped layer 130 is a mixed solution of HF and HNOs, the mixed solution of HF and HNOs is prepared from HF with a mass concentration ranging from 45% to 50% and HNOs with a mass concentration ranging from 60% to 70% in a volume ratio of 1:3 to 1:9.

Since the gettering effect of the doped layer is relatively consistent in different regions, after removing the doped layer, the impurity removal effect in the semiconductor substrate layer is better.

In other examples, after removing the doped layer, the method further comprises: cleaning the monocrystalline silicon wafer with a neutralizing cleaning solution, wherein, the neutralizing cleaning liquid is a mixed solution of HF and HCl.

Finally, drying is performed to complete the processing of the semiconductor substrate layer 200.

Monocrystalline silicon wafers without oxidation treatment are used as a control group, the relative values of the test results of the semiconductor substrate layer obtained by using the treating method of this example are as follows (monocrystalline silicon wafers without oxidation treatment are used as the reference value) :

| Group | Average minority carrier service life | The minimum minority carrier service life | The maximum minority carrier service life | Cell efficiency |
|---|---|---|---|---|
| Oxidation treatment group | +10% | +30% | +2% | +0.08% |
| Without oxidation treatment group | 1 | 1 | 1 | 1 |

It can be seen that, after the oxidation treatment, the average minority carrier service life and the minimum minority carrier service life of the semiconductor substrate layer have been greatly improved, and the maximum minority carrier service life and the efficiency of the produced cell have also been improved to a certain extent.

### EXAMPLE 2

This example provides a method for preparing a solar cell, comprising the method for treating a semiconductor substrate layer as provided in Example 1.

In the method for preparing a solar cell provided in this example, after treating the semiconductor substrate layer, the method further comprises the following steps: performing texturing treatment on the semiconductor substrate layer; forming a first intrinsic semiconductor layer on one side surface of the semiconductor substrate layer after performing texturing treatment, and forming a second intrinsic semiconductor layer on the other side surface of the semiconductor substrate layer; forming a first doped semiconductor layer on the side of the first intrinsic semiconductor layer facing away from the semiconductor substrate layer, and forming a second doped semiconductor layer on a side of the second intrinsic semiconductor layer facing away from the semiconductor substrate layer; forming a first transparent conductive film on a side of the first doped semiconductor layer facing away from the semiconductor substrate layer, and forming a second transparent conductive film on a side of the second doped semiconductor layer facing away from the semiconductor substrate layer; and forming a first grid electrode on a side of the first transparent conductive film facing away from the semiconductor substrate layer, and forming a second grid electrode on a side of the second transparent conductive film facing away from the semiconductor substrate layer.

Since the impurity removal effect of the semiconductor substrate layer is better, the photoelectric conversion efficiency of the solar cell finally formed by the solar cell preparation method in this example is higher and the service life is longer.

The above-mentioned embodiments are only examples to clearly illustrate the technical points of the present application and are not intended to limit the implementation. For those of ordinary skill in the art, changes or modifications in other different forms can also be made based on the above description. It is not necessary and impossible to exhaustively enumerate all implementations, and the obvious changes or modifications derived therefrom are still within the protection scope of the present invention.

## Claims

1. A method for treating a semiconductor substrate layer, comprising a step of providing a monocrystalline silicon wafer, a step of spraying a diffusion liquid onto a surface of the monocrystalline silicon wafer, and a step of annealing the monocrystalline silicon wafer; wherein the method further comprises the following steps:
subjecting the monocrystalline silicon wafer to a surface oxidation treatment before spraying the diffusion liquid onto the surface of the monocrystalline silicon wafer, wherein the surface oxidation treatment is used for improving the lyophilicity of the surface of the monocrystalline silicon wafer to the diffusion liquid, to improve the uniformity of the annealing the monocrystalline silicon wafer.

2. The method for treating a semiconductor substrate layer of claim 1, wherein the step of surface oxidation treatment comprises: spraying an oxygen-containing gas onto the surface of the monocrystalline silicon wafer;
preferably, the oxygen-containing gas comprises ozone;
preferably, the concentration of the oxygen-containing gas is in a range from 50 ppm to 300 ppm;
preferably, the injection rate of the oxygen-containing gas is in a range from 0.5slm to 5slm;
preferably, the oxygen-containing gas is sprayed for a period ranging from 5 seconds to 30 seconds; and
preferably, in the step of the surface oxidation treatment, the oxygen-containing gas is sprayed vertically toward the surface of the monocrystalline silicon wafer.

3. The method for treating a semiconductor substrate layer of claim 1, wherein the surface oxidation treatment causes an oxide layer to be formed on the surface of the monocrystalline silicon wafer;
the step of performing diffusion annealing treatment on the surface of the monocrystalline silicon wafer causes the diffusion ions in the diffusion liquid to diffuse into the partial thickness of the monocrystalline silicon wafer through the oxide layer, to form a doped layer covered by the oxide layer in the partial thickness of the monocrystalline silicon wafer, and the diffusion annealing treatment is suitable for migrating impurities inside the monocrystalline silicon wafer to the doped layer; and
preferably, the diffusion annealing treatment is a chain diffusion annealing treatment.

4. The method for treating a semiconductor substrate layer of claim 3, wherein the oxide layer has a thickness ranging from 0.5nm to 20nm;
preferably, the material of the monocrystalline silicon wafer comprises monocrystalline silicon, and the material of the oxide layer comprises silicon oxide.

5. The method for treating a semiconductor substrate layer of claim 3, wherein the step of performing diffusion annealing treatment on the surface of the monocrystalline silicon wafer comprises: a heating process, a heat preservation process, and a cooling process in sequence, the heat preservation process is suitable for diffusing the diffusion ions into the partial thickness of the monocrystalline silicon wafer, and the cooling process is suitable for migrating impurities inside the monocrystalline silicon wafer into the doped layer;
preferably, the temperature of the heat preservation process is in a range from 800°C to 900°C; and
preferably, the doped layer has a thickness ranging from 0.15 µm to 0.3 µm.

6. The method for treating a semiconductor substrate layer of any one of claims 1 to 5, wherein the diffusion liquid comprises a phosphoric acid solution; and
preferably, the mass concentration of the phosphoric acid solution is in a range from 2% to 12%.

7. The method for treating a semiconductor substrate layer of any one of claims 1 to 5, wherein before performing surface oxidation treatment on the monocrystalline silicon wafer, the method further comprises: removing a damaged layer on the surface of the monocrystalline silicon wafer; performing a dehydration treatment to the surface of the monocrystalline silicon wafer using a hydrophobic solution after removing the damaged layer on the surface of the monocrystalline silicon wafer; and drying the monocrystalline silicon wafer after the dehydration treatment;
preferably, an etching solution used for removing the damaged layer on the surface of the monocrystalline silicon wafer is a NaOH aqueous solution, a KOH aqueous solution, or a mixed solution of HF and HNO₃;
preferably, the hydrophobic solution comprises a HF aqueous solution;
preferably, the mass concentration of the NaOH aqueous solution is in a range from 2% to 15%;
preferably, the mass concentration of the KOH aqueous solution is in a range from 2% to 15%; and
preferably, the mixed solution of HF and HNOs is prepared from HF with a mass concentration ranging from 45% to 50% and HNOs with a mass concentration ranging from 60% to 70% in a volume ratio of 1:3 to 1:9.

8. The method for treating a semiconductor substrate layer of claim 3, wherein after performing the diffusion annealing treatment, the method further comprises: removing the oxide layer; and removing the doped layer after removing the oxide layer;
preferably, the etching solution for removing the oxide layer is an HCl aqueous solution, and the mass concentration of HCl in the HCl aqueous solution is in a range of 4% to 5%;
preferably, the etching solution used for removing the doped layer is a NaOH aqueous solution or a KOH aqueous solution;
preferably, a mixed solution of HF and HNOs is used for removing the oxide layer and removing the doped layer;
preferably, the mass concentration of the NaOH aqueous solution is in a range from 2% to 15%;
preferably, the mass concentration of the KOH aqueous solution is in a range from 2% to 15%; and
preferably, the mixed solution of HF and HNO₃ is prepared from HF with a mass concentration ranging from 45% to 50% and HNOs with a mass concentration ranging from 60% to 70% in a volume ratio of 1:3 to 1:9.

9. The method for treating a semiconductor substrate layer of claim 8, wherein after removing the doped layer, the method further comprises: cleaning the monocrystalline silicon wafer using a neutralizing cleaning solution;
preferably, the neutralizing cleaning solution is a mixed solution of HF and HCl.

10. A method for preparing a solar cell, wherein the method comprises the method for treating a semiconductor substrate layer of any one of claims 1 to 9.

11. The method for preparing a solar cell of claim 10, wherein after treating the semiconductor substrate layer, the method further comprises the following steps:
performing texturing treatment on the semiconductor substrate layer;
forming a first intrinsic semiconductor layer on one side surface of the semiconductor substrate layer after performing texturing treatment, and forming a second intrinsic semiconductor layer on the other side surface of the semiconductor substrate layer;
forming a first doped semiconductor layer on the side of the first intrinsic semiconductor layer facing away from the semiconductor substrate layer, and forming a second doped semiconductor layer on a side of the second intrinsic semiconductor layer facing away from the semiconductor substrate layer;
forming a first transparent conductive film on a side of the first doped semiconductor layer facing away from the semiconductor substrate layer, and forming a second transparent conductive film on a side of the second doped semiconductor layer facing away from the semiconductor substrate layer; and
forming a first grid electrode on a side of the first transparent conductive film facing away from the semiconductor substrate layer, and forming a second grid electrode on a side of the second transparent conductive film facing away from the semiconductor substrate layer.
